# FASCICULE DE BREVET EUROPEEN

(11) **EP 3 370 263 B1**
(45) Date de publication et mention de la délivrance du brevet: **25.12.2019**
(21) Numéro de dépôt: 18158092.9
(22) Date de dépôt: 22.02.2018
(51) Int. Cl.: H01L 31/048, H01L 31/042, H01L 31/054

(54) **CELLULE PHOTOVOLTAÏQUE ÉQUIPÉE**
BESTÜCKTE FOTOVOLTAIKZELLE
EQUIPPED PHOTOVOLTAIC CELL

(30) Priorité: 02.03.2017 FR 1700206
(43) Date de publication de la demande: 05.09.2018
(73) Titulaire: THALES, 92400 Courbevoie (FR)
(72) Inventeur: D'ABRIGEON, Laurent, 83440 CALLIAN (FR); MALORON, Frédéric, 06220 GOLFE JUAN (FR); VOIRIN, Jean-Noël, 06550 LA ROQUETTE SUR SIAGNE (FR)
(74) Mandataire: Brunelli, Gérald

(56) Documents cités:
- WO-A1-2009/109084
- FR-A1- 2 864 347
- US-A- 3 532 551
- US-A1- 2010 132 793
- US-A1- 2016 172 520
- Helios Technology: "Solar kits M12 and M20, H12 series photovoltaic module,H200 series photovoltaic module" In: "Solar kits M12 and M20, H12 series photovoltaic module,H200 series photovoltaic module", 1 mai 1999 (1999-05-01), XP055427943, * le document en entier *

## Description

La présente invention porte sur une cellule photovoltaïque équipée, notamment pour générateur solaire.

Une cellule photovoltaïque équipée, également dénommé cellule solaire équipée, est un composant électronique qui, exposé à la lumière (photons), produit de l'électricité grâce à l'effet photovoltaïque.

La puissance électrique obtenue est proportionnelle à la puissance lumineuse incidente sur la cellule photovoltaïque équipée et à la surface de la cellule photovoltaïque équipée.

Les cellules photovoltaïques sont produites sur un substrat, ou "wafer" en langue anglaise, qui est une structure cristalline nativement circulaire mais ensuite découpée suivant la géométrie souhaitée, appelée encore cellule native.

Les cellules photovoltaïques sont ensuite équipées d'interconnecteurs, recouvertes d'un verre de protection, ou "coverglass" en langue anglaise, et équipées d'une diode de protection à assembler à côté de la cellule photovoltaïque, dans la plupart des technologies, pour former une cellule équipée.

Un réseau photovoltaïque est un assemblage ou pavage de cellules photovoltaïques équipées qui sont pavées côte à côte.

Le rendement énergétique de l'effet photovoltaïque diminue avec la température, d'où l'intérêt d'avoir un réseau photovoltaïque le plus froid possible afin d'améliorer son rendement.

US 3,532,551 divulgue une cellule photovoltaïque équipée comprenant un verre de protection dont les parties dépassant de la cellule photovoltaïque sont pourvues d'une surface optique réfléchissante.

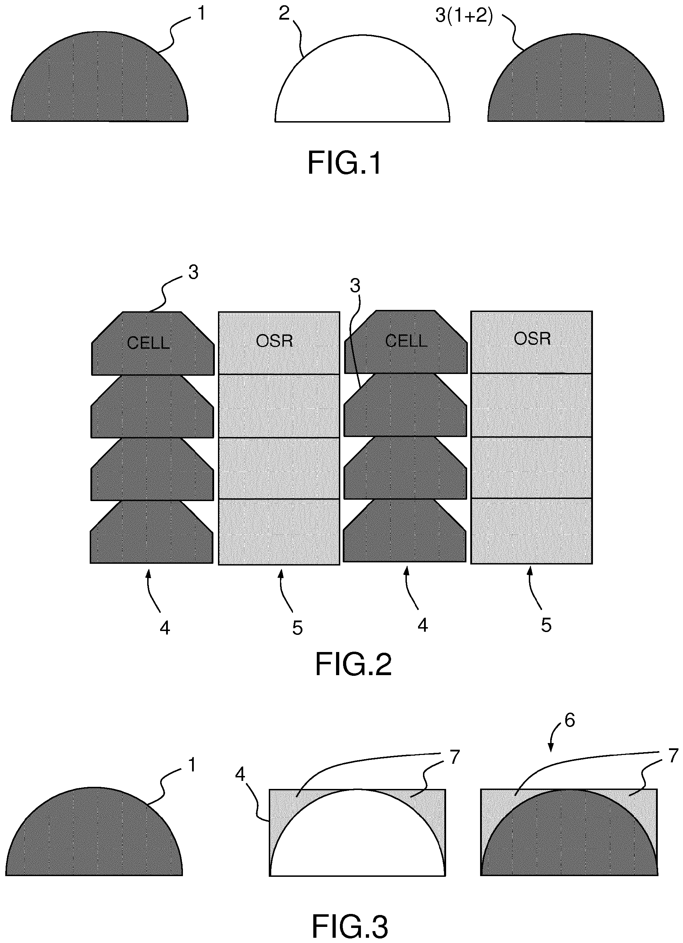

La figure 1 illustre schématiquement, sur un exemple non limitatif d'une cellule photovoltaïque 1 de forme en demi-cercle, sur laquelle un verre de protection 2 taillé à la même forme que celui de la cellule photovoltaïque 1, et disposé sur la cellule photovoltaïque 1 pour former une cellule photovoltaïque équipée 3.

Dans le cas des générateurs solaires pour application spatiale et pour les missions se rapprochant du soleil, le problème de montée en température et de baisse de rendement est résolu par la pose de réflecteurs solaires optiques ou "optical solar reflector" en langue anglaise d'acronyme OSR, ou miroirs) entre les cellules, comme par exemple illustré sur la figure 2 ou sont alternées des rangées 4 de cellules photovoltaïques équipées 3 semblables à celles de la figure 1, mais sur cet exemple de forme demi-hexagonale, et des rangées 5 de miroirs ou OSR.

Le défaut d'une telle solution est la perte de surface active et aussi le besoin d'ajouter des composants (OSR ou miroirs) sur le réseau pour faire baisser la température. Cela est complexe et de coût élevé, et donc généralement pas appliqué à des générateurs solaires pour des missions sur orbites terrestres pour lesquelles un tel surcoût est trop important par rapport à l'échauffement plus limité des cellules photovoltaïques par rapport à une mission chaude se rapprochant plus du Soleil.

Un but de l'invention est d'améliorer le rendement de cellules solaires en limitant la montée en température des cellules photovoltaïques, et cela à faible coût.

Aussi, il est proposé, selon un aspect de l'invention, une cellule photovoltaïque équipée comprenant un premier ensemble d'une seule cellule photovoltaïque en forme de demi-cercle ou de demi-hexagone et un verre de protection rectangulaire, de longueur celle de la base du demi-cercle ou du demi-hexagone, disposé sur la face active du premier ensemble, la surface du verre de protection recouvrant plus que la totalité de la face active du premier ensemble, le contour de la cellule photovoltaïque étant inscrit dans le contour rectangulaire du verre de protection, et comprenant un deuxième ensemble d'au moins une portion du verre de protection dépassant de la face active du premier ensemble, le deuxième ensemble comprenant une surface optique réfléchissante.

Une telle cellule photovoltaïque équipée permet d'obtenir un rapport ou ratio absorptivité/émissivité (*α*/*ε*) sur le deuxième ensemble qui est plus faible que celui du reste de la cellule photovoltaïque équipée ou premier ensemble d'au moins une cellule photovoltaïque. Ainsi selon l'invention le rapport absorptivité/émissivité moyen de la cellule photovoltaïque équipée est réduit et par conduction thermique dans le plan, la partie active de la cellule est refroidi et le rendement est amélioré.

En outre le coût est fortement limité, car il n'est pas ajouté de composants faisant sensiblement baisser le taux de remplissage des panneaux solaires et augmentant du coup sensiblement leur masse et encombrement. La présente invention améliore nettement le rendement du réseau sans augmenter la masse de manière significative, et ce à faible coût.

Dans un mode de réalisation, tout le deuxième ensemble comprend une surface optique réfléchissante.

Ainsi, on optimise la place disponible pour réfléchir la lumière et limiter la chauffe des cellules photovoltaïques.

Selon un aspect de l'invention, la cellule photovoltaïque est en forme de demi-cercle.

En variante de cet aspect de l'invention, la cellule photovoltaïque est en forme de demi-hexagone.

Les cellules photovoltaïques de dernière génération ou des coins biseautés en forme sensiblement de demi-hexagone.

Selon un aspect de l'invention, le verre de protection est rectangulaire.

Une forme rectangulaire est simple à réaliser et de coût réduit et facilite le positionnement des cellules équipées et réduit les coûts de mise en place lors de la pose.

Selon un aspect de l'invention, le premier ensemble comprend une seule cellule photovoltaïque.

Ainsi, même avec une seule cellule, la partie réfléchissante a un ratio émissivité/absorptivité plus élevé que la partie active et que le support de la cellule équipée, ce qui fait baisser par conduction dans le plan la température de la partie active de la cellule photovoltaïque et conduit à une meilleure efficacité.

Selon un aspect de l'invention:
- le premier ensemble comprend une seule cellule photovoltaïque ;
- la cellule photovoltaïque est en forme de demi-cercle ou de demi-hexagone ;
- le verre de protection est rectangulaire ; et
- la longueur du verre de protection rectangulaire est celle de la base du demi-cercle ou du demi-hexagone.

Ainsi, on remplace le coin perdu par une surface réfléchissante qui permet d'abaisser la température et d'augmenter le rendement sans aller au détriment du facteur de remplissage.

Selon un aspect de l'invention, le contour de la cellule photovoltaïque est inscrit dans le contour rectangulaire du verre de protection.

Ainsi, quelle que soit la géométrie de la cellule (ce qui permet de l'optimiser en termes de coût de fabrication), le fait de se ramener au rectangle circonscrit en utilisant l'espace perdu pour le remplacer par une surface réfléchissante permet d'abaisser la température et d'augmenter le rendement sans aller au détriment du facteur de remplissage.

Dans un mode de réalisation, ladite surface réfléchissante comprend une argenture disposée sur la face du deuxième ensemble en contact avec la face active du premier ensemble.

C'est un moyen bien connu de réaliser à coût réduit une surface optique réfléchissante ou miroir.

Il est également proposé, selon un autre aspect de l'invention, un générateur solaire comprenant au moins une cellule photovoltaïque équipée tel que précédemment décrit.

L'invention sera mieux comprise à l'étude de quelques modes de réalisation décrits à titre d'exemples nullement limitatifs et illustrés par les dessins annexés sur lesquels :
- la figure 1 illustre schématiquement une cellule photovoltaïque et son équipement avec verre de protection de géométrie identique, selon l'état de l'art ;
- la figure 2 illustre schématiquement un arrangement de cellules photovoltaïques équipées avec des miroirs, selon l'état de l'art ;
- la figure 3 illustre schématiquement une cellule photovoltaïque équipée selon un aspect de l'invention avec une cellule photovoltaïque en forme de demi-cercle ;
- la figure 4 illustre schématiquement un arrangement de cellules photovoltaïques équipées avec des cellules en forme de demi-hexagone pour un générateur solaire selon un aspect de l'invention ; et
- la figure 5 illustre schématiquement le gain de puissance d'un réseau photovoltaïque (courbe GS) et la baisse de température non opérationnelle (courbe Tnop) en fonction du taux de surface optique réfléchissante, selon un aspect de l'invention, la courbe de rendement est un exemple basé sur les propriétés des réseaux à base d'AsGa triple jonction dans le cas d'une application spatiale avec échanges radiatifs uniquement.

Sur les différentes figures, les éléments ayant des références identiques sont identiques.

Sur la figure 3 est représentée, de manière non limitative, une cellule photovoltaïque 1 par exemple en forme de demi-cercle, sur laquelle un verre de protection 4 rectangulaire est disposé. En l'espèce, la cellule photovoltaïque équipée 6 résultante ne comprend qu'une cellule photovoltaïque 1.

Sur le cas représenté, la longueur du verre de protection rectangulaire est celle de la base du demi-cercle. En variante, la longueur du verre de protection rectangulaire peut être égale à celle de la base du demi-hexagone en cas de cellule en forme de demi-hexagone.

En outre, sur le cas représenté, le contour de la cellule photovoltaïque est inscrit dans le contour rectangulaire du verre de protection.

Ainsi, on optimise la compacité de l'arrangement des cellules photovoltaïques équipées sur un panneau de générateur solaire.

Les parties 7 du verre de protection 4, ne recouvrant pas la face active de la cellule photovoltaïque 1, comprennent une surface optique réfléchissante comme un miroir.

Par exemple, les parties 7 sont argentées, ou, en d'autres termes, comprennent une argenture, formant une surface optique réfléchissante ou miroir.

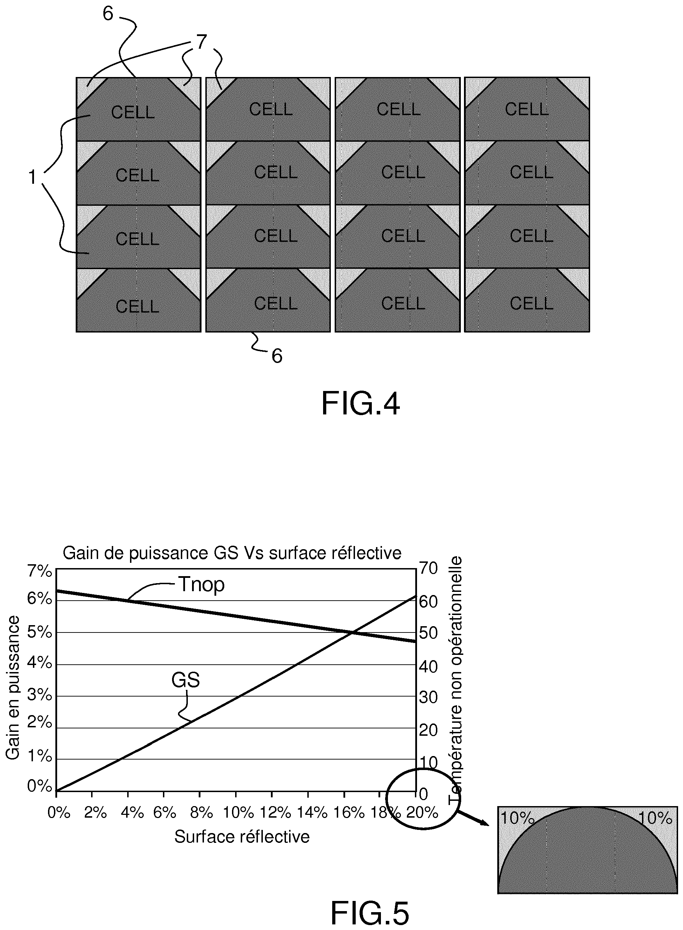

La figure 4 représente schématiquement un arrangement pour générateur solaire, muni de cellules photovoltaïques équipées 6 munis de cellules photovoltaïques 1, similaires à ceux de la figure 3, mais sur cet exemple les cellules photovoltaïques 1 sont en forme de demi-hexagone.

La figure 5 illustre schématiquement le gain de puissance GS d'une cellule photovoltaïque équipée 6 selon la figure 3, en fonction de la surface optique réfléchissante 7.

Dans ce cas, lorsque la cellule photovoltaïque équipée 6 de la figure 3 est tel que lorsque le pourcentage de surface optique réfléchissante du verre de protection rectangulaire est de 20%, le gain de puissance est de 6%.

Le coût du verre de protection est négligeable dans le coût du réseau et le surcoût de la métallisation est largement couvert par le gain important (jusqu'à 6% sur la puissance).

La figure 5 illustre également la baisse de température non opérationnelle Tₙₒₚ en fonction du taux de surface optique réfléchissante, la température non opérationnelle Tₙₒₚ représentant la température lorsque le réseau n'est pas actif. Lorsque le réseau est utilisé la température opérationnelle Tₒₚ est inférieure à la température non opérationnelle Tₙₒₚ en raison du bilan énergétique de la cellule photovoltaïque pour lequel la puissance électrique est retirée (puissance sortante). La température opérationnelle Tₒₚ baisse dans une même proportion que la température non opérationnelle Tₙₒₚ et garantit donc une meilleure efficacité en fonctionnement.

## Revendications

1. Cellule photovoltaïque équipée (6) comprenant un premier ensemble d'une seule cellule photovoltaïque (1) en forme de demi-cercle ou de demi-hexagone et un verre de protection (4) rectangulaire, de longueur celle de la base du demi-cercle ou du demi-hexagone, disposé sur la face active du premier ensemble, la surface du verre de protection (4) recouvrant plus que la totalité de la face active du premier ensemble, le contour de la cellule photovoltaïque (1) étant inscrit dans le contour rectangulaire du verre de protection (4), et comprenant un deuxième ensemble d'au moins une portion du verre de protection (4) dépassant de la face active du premier ensemble, le deuxième ensemble comprenant une surface optique réfléchissante (7).

2. Cellule photovoltaïque équipée (6) selon la revendication 1, dans lequel tout le deuxième ensemble comprend une surface optique réfléchissante (7).

3. Cellule photovoltaïque équipée (6) selon l'une des revendications précédentes, dans lequel ladite surface réfléchissante comprend une argenture (7) disposée sur la face du deuxième ensemble en contact avec la face active du premier ensemble.

4. Générateur solaire comprenant au moins une cellule photovoltaïque équipée (6) selon l'une des revendications précédentes.

## Patentansprüche

1. Bestückte Fotovoltaikzelle (6), beinhaltend eine erste Baugruppe mit einer einzigen Fotovoltaikzelle (1) in Form eines Halbkreises oder eines halben Sechsecks und ein rechteckiges Schutzglas (4), dessen Länge diejenige der Grundfläche des Halbkreises oder des halben Sechsecks ist, angeordnet an der aktiven Seite der ersten Baugruppe, wobei die Oberfläche des Schutzglases (4) mehr als die Gesamtheit der aktiven Seite der ersten Baugruppe bedeckt, wobei die Kontur der Fotovoltaikzelle (1) innerhalb der rechteckigen Kontur des Schutzglases (4) liegt, und beinhaltend eine zweite Baugruppe mit mindestens einem Abschnitt des Schutzglases (4), welcher über die aktive Seite der ersten Baugruppe hinausragt, wobei die zweite Baugruppe eine reflektierende optische Oberfläche (7) beinhaltet.

2. Bestückte Fotovoltaikzelle (6) nach Anspruch 1, wobei die ganze zweite Baugruppe eine reflektierende optische Fläche (7) beinhaltet.

3. Bestückte Fotovoltaikzelle (6) nach einem der vorhergehenden Ansprüche, wobei die reflektierende Oberfläche eine Versilberung (7) beinhaltet, welche an der Seite der zweiten Baugruppe in Kontakt mit der aktiven Seite der ersten Baugruppe angeordnet ist.

4. Solargenerator, beinhaltend mindestens eine bestückte Fotovoltaikzelle (6) nach einem der vorhergehenden Ansprüche.

## Claims

1. Equipped photovoltaic cell (6) comprising a first assembly of a single photovoltaic cell (1) semicircular or semihexagonal in shape and a rectangular protection glass (4) of the length of the base of the semicircle or of the semihexagon, positioned on the active face of the first assembly, the surface of the protective glass (4) covering more than the entirety of the active face of the first assembly, the outline of the photovoltaic cell (1) fitting inside the rectangular outline of the protective glass (4), and comprising a second assembly of at least one portion of the protective glass (4) extending from the active face of the first assembly, the second assembly comprising an optical reflective surface (7) .

2. Equipped photovoltaic cell (6) according to claim 1, wherein the second assembly comprises an optical reflective surface (7).

3. Equipped photovoltaic cell (6) according to one of the preceding claims, wherein said reflective surface comprises a silvering (7) arranged on the face of the second assembly that makes contact with the active face of the first assembly.

4. Solar generator comprising at least one equipped photovoltaic cell (6) according to one of the preceding claims.
